# EUROPÄISCHE PATENTSCHRIFT

(11) **EP 0 319 660 B1**
(45) Veröffentlichungstag und Bekanntmachung des Hinweises auf die Patenterteilung: **03.02.1993**
(21) Anmeldenummer: 88115257.3
(22) Anmeldetag: 17.09.1988
(51) Int. Cl.: H03K 17/08

(54) **Anordnung zum Befreien eines Halbleiterschalters vor hoher Sperrspannungsbeanspruchung sowie Anwendung hierzu**
Arrangement for relieving a semiconductor switch from high blocking voltage stress, and its use
Montage pour affranchir un commutateur à semi-conducteur d'une sollicitation de tension de blocage élevée ainsi que son application

(30) Priorität: 05.12.1987 DE 3741221
(43) Veröffentlichungstag der Anmeldung: 14.06.1989
(73) Patentinhaber: ANT Nachrichtentechnik GmbH, D-71522 Backnang (DE)
(72) Erfinder: Reustle, Hans, Dipl.- Ing., D-7152 Aspach 1 (DE)

(56) Entgegenhaltungen:
- DE-A- 2 028 435
- DE-A- 3 422 777
- GB-A- 2 132 433

## Beschreibung

Die Erfindung betrifft eine Anordnung zum Befreien eines Halbleiterschalters vor hoher Sperrspannungsbeanspruchung sowie eine Anwendung hierzu
Aus der DE-A-36 09 375 ist eine Anordnung zum Befreien eines Halbleiterschalters vor hoher Sperrspannungsbeanspruchung beim Ausschalten bekannt. Zur Aufnahme der Energie beim Ausschalten ist der Halbleiterschalter mit einer Kondensator-Diodenbeschaltung, einem sogenannten Snubber, ausgestattet. An die Diode dieses Snubbers ist ein Stromwandlertransformator angeschlossen, über den die freiwerdende Entladungsenergie des Kondensators in eine Spannungsquelle, z.B. die den Laststrom über eine Nutzimpedanz treibende Spannungsquelle, rückgespeist wird.

Bei Anordnungen gemäß der DE-A-26 44 715 sind den zu schützenden Halbleiterschaltern Umschwingkreise - bestehend aus Kondensatoren, Induktivitäten und Dioden - zugeordnet. Die Anordnungen gemäß DE-A-26 44 715 gestatten zwar die Ausnutzung der Energie beim Abschalten des Halbleiterschalters, bedingen jedoch aufwendige Schaltungen. Auch ist die Dimensionierung dieser Schaltungen kritisch. Aus der DE-A-34 27 492 ist es bekannt, einen Halbleiterschalter mit einem Spannungsbegrenzungselement auszustatten, welches einen Umschwingkreis umfaßt. Es ist auch bekannt, zum Schutz vor überspannungsbeanspruchungen einen Halbleiterschalter mit einem sogenannten RCD-Netzwerk zu beschalten (DE-A-35 38 184; Electronic Design News, Mai 1981, Seiten 126 - 130). Diese Realisierung basiert auf der Vernichtung von Energie in einem ohmschen Widerstand.

Aus der GB-A-21 32 433 bzw. aus der DE-A-20 28 435 ist eine Schaltung bekannt zur Steuerung einer induktiven Last. Diese induktive Last liegt über einer Diode und einem Halbleiterschalter an einer Gleichspannungsversorgungsquelle. Parallel zu dieser Diode ist bei der Anordnung gemäß GB-A-21 32 433 die Serienschaltung eines Kondensators und einem Thyristor angeordnet. Über eine weitere Diode zwischen der induktiven Last und dem Kondensator kann die Energie der induktiven Last an den Kondensator abgegeben werden. Über eine Steuereinrichtung sind Thyristor und Halbleiterschalter gleichzeitig einschaltbar. Der Halbleiterschalter wird abgeschaltet, wenn ein bestimmter Grenzstrom erreicht ist.

Aufgabe der Erfindung ist es eine Anordnung zum Befreien eines Halbleiterschalters vor zu hoher Sperrspannungsbeanspruchung anzugeben, welche eine Rückgewinnung der Energie auf einfache Weise gestattet, und welche insbesondere ohne zusätzliche induktive Bauelemente auskommt. Außerdem soll eine Anwendung angegeben werden. Die Aufgabe wird bezüglich der Anordnung durch die Merkmale des Patentanspruchs 1 und bezüglich der Anwendung durch die Merkmale des Patentanspruchs 2 gelöst. Anspruch 3 zeigt eine vorteilhafte Ausgestaltung der Anordnung auf.

Die Erfindung zeichnet sich durch einen kleinen zusätzlichen Bauteileaufwand aus. Bei einer verlustarmen Spannungsbegrenzung ist lediglich ein Halbleiterschalter und eine Diode zusätzlich erforderlich. Durch die Energierückspeisung läßt sich beispielsweise bei einer Anwendung in einem Schaltregler der Wirkungsgrad auf einfache Weise erheblich verbessern. Probleme, wie sie bei Umschwingtechniken auftreten - Resonanzabstimmung, Stabilität, Verzögerungszeiten -, sind nicht zu befürchten.

Anhand der Zeichnungen wird ein Ausführungsbeispiel der Erfindung nun näher erläutert. Es zeigen
- Fig. 1: ein Prinzipschaltbild für einen Halbleiterschalter mit Schutzbeschaltung eingesetzt in einem Schaltregler und
- Fig. 2: ein Prinzipschaltbild nach Figur 1 mit zusätzlicher Ansteuerschaltung für die Halbleiterschalter.

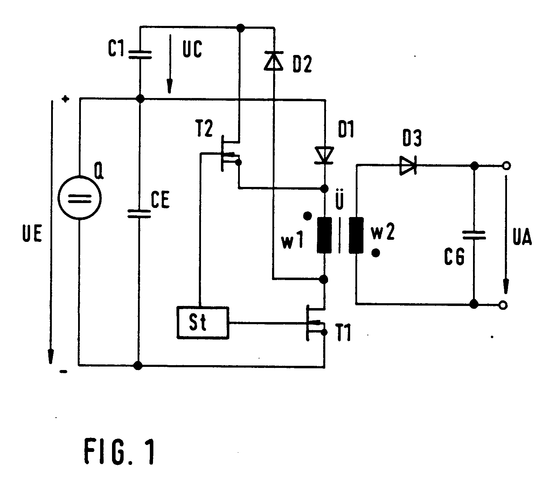

In Fig. 1 ist ein Halbleiterschalter T1 als Stellglied eines Schaltreglers dargestellt. Eine Eingangsgleichspannungsquelle Q, die mit einem Eingangsglättungskondensator CE beschaltet ist, ist an die Serienschaltung, bestehend aus einer Diode D1, der Primärwicklung w1 des Schaltregler-Leistungsübertragers Ü und der Schaltstrecke des Halbleiterschalters - Feldeffekttransistor T1 -, angeschlossen. Die Diode D1 ist hierbei so gepolt, daß im Leitendzustand des Feldeffekttransistors T1 ein Strom von der Eingangsgleichspannungsquelle Q durch die Primärwicklung w1 fließen kann. Der Leistungsübertrager Ü stellt für den Feldeffekttransistor T1 eine Nutzimpedanz, hier die Schaltreglerhauptinduktivität, dar. Der Schaltregler ist als Sperrwandler geschaltet. Die Primärwicklung w2 des Leistungsübertragers Ü ist mit einer üblichen Diode D3 und einem Glättungskondensator CG beschaltet, an dessen Klemmen die Ausgangsspannung UA abgenommen werden kann. Zwischen einer Hauptelektrode des Feldeffekttransistors T1 und einer Klemme der Eingangsgleichspannungsquelle Q ist eine Entlastungsschaltung - ein sogenannter "Snubber" - vorgesehen, welche den Halbleiterschalter vor zu hoher Sperrspannungsbeanspruchung beim Ausschalten schützt. Die Entlastungsschaltung besteht aus der Serienschaltung einer Diode D2 und einem Kondensator C1. Die Diode D2 ist so gepolt, daß im Sperrzustand des Feldeffekttransistors T1 ein Ladestrom für den Kondensator C1 fließen kann. Zwischen der Verbindungsleitung der Diode D2 mit dem Kondensator C1 einerseits und der Verbindungsleitung der Diode D1 mit der Primärwicklung w1 andererseits ist ein weiterer Halbleiterschalter - Feldeffekttransistor F2 - angeordnet, mittels dessen der Kondensator C1 an die Nutzimpedanz entladbar ist.
Im hier gezeigten Ausführungsbeispiel liegt die Entlastungsschaltung zwischen Drain und Pluspol der Eingangsgleichspannungsquelle Q. Es ist natürlich möglich, die Entlastungsschaltung auch zwischen Drain und Minuspol der Eingangsgleichspannungsquelle Q einzufügen. Hierzu bedarf es lediglich einer geringen Schaltungsmodifikation.

Die Funktion der Schaltung gemäß Figur 1 ist folgendermaßen: Wenn der Feldeffekttransistor T1 mittels der Steuerschaltung St eingeschaltet wird, wird die primärseitige Induktivität des Leistungsübertragers Ü über die Diode D1 und die Schaltstrecke des Feldeffekttransistors T1 geladen. Wird nun der Feldeffekttransistor T1 durch die Steuerschaltung St geöffnet, ändert sich die Polarität an der Primärwicklung w1. Es fließt ein Entlastungsstrom über die Diode D2 auf den Kondensator C1. In diesem Kondensator C1 wird die sogenannte "Entlastungsenergie" so lange zwischengespeichert, bis von der Steuerschaltung St ein Befehl zur Wiedereinschaltung des Feldeffekttransistors T1 gegeben wird. Gleichzeitig mit Uberführen des Feldeffekttransistors T1 in den Leitendzustand wird auch der Feldeffekttransistor T2 mittels der Steuerschaltung St leitend gesteuert. An der Primärwicklung w1 liegt dann die Spannung UE+UC, wobei UE die Eingangsgleichspannung UE der Quelle Q und UC die Spannung am Kondensator C1 darstellt. Nun kann sich der Kondensator C1 durch die Energieabgabe an den Leitungsübertrager Ü bis auf die Spannung - UD1 der Diode D1 entladen. Damit ist mit einfachen Mitteln eine nutzbringende Energierückspeisung erreicht.

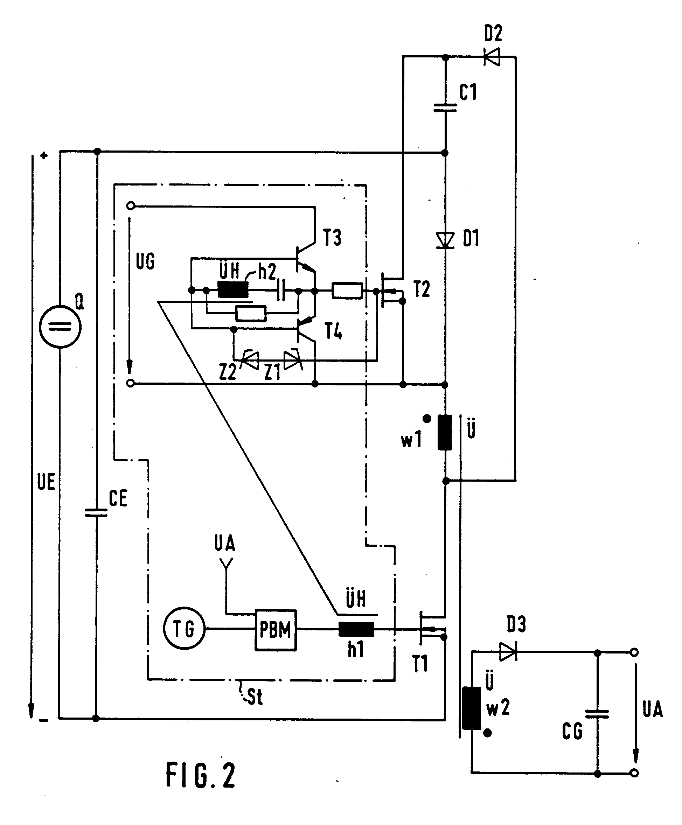

Zur Ansteuerung der beiden Feldeffekttransistoren T1 und T2 eignet sich eine Steuerschaltung St, die im einzelnen in Figur 2 dargestellt ist. Die Einschaltpulse für den Feldeffekttransistor T1 liefert üblicherweise ein Pulsbreitenmodulator PBM, der von einem Taktgenerator TG gesteuert ist. Die Ausgangspulse des Taktgenerators TG werden in Abhängigkeit der Höhe der Ausgangsspannung UA in ihrer Breite variiert. In die Verbindungsleitung zwischen Pulsbreitenmodulator PBM und Gateanschluß des Feldeffekttransistors T1 ist die Primärwicklung h1 eines Hilfsübertragers ÜH eingefügt. Die Sekundärwicklung h2 des Hilfsübertragers ÜH ist jeweils mit dem Emitter-Basis-Kreis einer Gegentakttreiberstufe, bestehend aus den komplementären Bipolartransistoren T3 und T4 beschaltet. Das Ausgangssignal der Gegentakttreiberstufe steuert den Feldeffekttransistor T2. Somit erhält der Feldeffekttransistor T2 synchron zum Feldeffekttransistor T1 seine Einschalt- bzw. Sperrimpulse. Die antiseriell geschalteten Zenerdioden Z1 und Z2 zwischen dem Gate des Feldeffekttransistors T2 und der Basis eines Treibertransistors stellen eine Schutzbeschaltung dar. Zur Stromversorgung der Gegentakttreiberstufe ist eine Hilfsspannung UG nötig, die gegebenenfalls aus der Eingangsgleichspannungsquelle Q gewonnen werden kann. Die Gegentakttreiberstufe kann mit einer üblichen Antisättigungseinrichtung ausgestattet werden.

## Patentansprüche

1. Anordnung zum Befreien eines Halbleiterschalters (T1) vor hoher Sperrspannungsbeanspruchung beim Ausschalten, mit folgenden Merkmalen:
- einer Eingangsgleichspannungsquelle (Q),
- einer an die Eingangsgleichspannungsquelle (Q) angeschlossenen Serienschaltung, bestehend aus einer Nutzimpedanz (Ü) und dem zu schützenden Halbleiterschalter (T1),
- einer Serienschaltung, bestehend aus einer Diode (D2) und einem Kondensator (C1), welche zwischen einer Hauptelektrode des zu schützenden Halbleiterschalters (T1) und einer Klemme der Eingangsgleichspannungsquelle (Q) angeordnet ist, wobei die Diode (D2) so gepolt ist, daß im Sperrzustand des zu schützenden Halbleiterschalters (T1) ein Ladestrom für den Kondensator (C1) fließen kann,
- einer weiteren Diode(D1) im Stromkreis der Eingangsgleichspannungsquelle (Q), Nutzimpedanz (Ü) und zu schützendem Halbleiterschalter (T1), wobei diese weitere Diode derart gepolt ist, daß im Leitendzustand des Halbleiterschalters (T1) ein Strom von der Eingangsgleichspannungsquelle (Q) durch die Nutzimpedanz (Ü) fließen kann,
- einem weiteren Halbleiterschalter (T2), mittels dessen eine Verbindung zwischen dem Kondensator (C1) und der Nutzimpedanz (Ü) für die Entladung des Kondensators (C1) beim Einschalten des zu schützenden Halbleiterschalters (T1) herstellbar ist,
- Schaltmitteln (ÜH, T3, T4) zur Leitendsteuerung des weiteren Halbleiterschalters (T2) synchron zur Leitendsteuerung des Halbleiterschalters (T1) mittels einer den beiden Halbleiterschaltern (T1, T2) zugeordneten Steuerschaltung (St), die es ermöglicht, daß der weitere Halbleiterschalter (T2) seine Einschalt impulse synchron zum Halbleiterschalter (T1) erhält, dadurch gekennzeichnet, daß der weitere Halbleiterschalter (T2) seine Sperrimpulse synchron zum Halbleiterschalter von der Steuerschaltung (St) erhält.

2. Anwendung der Anordnung nach Anspruch 1 für einen Schaltregler, wobei die Nutzimpedanz (Ü), die Schaltreglerhauptinduktivität und der schützende Halbleiterschalter (T1) das Schaltregler-Stellglied darstellt.

3. Anordnung nach Anspruch 1, dadurch gekennzeichnet, daß die Schaltmittel zur Leitendsteuerung des weiteren Halbleiterschalters (T2) aus einem Hilfsübertrager (ÜH) bestehen, dessen Primärwicklung (h1) im Steuerkreis des zu schützenden Halbleiterschalters (T1) angeordnet ist und dessen Sekundärwicklung (h2) in einer Treiberstufe (T3, T4) zur Leitendsteuerung des weiteren Halbleiterschalters (T2) so angeordnet ist, daß beide Halbleiterschalter (T1, T2) jeweils gleichzeitig leitend steuerbar sind.

## Claims

1. An arrangement for freeing a semiconductor switch (T1) from high forward blocking voltage stresses during turn-off, the arrangement including the following features:
- an input direct voltage source (Q);
- a series connection of a useful impedance (Ü) and the semiconductor switch (T1) to be protected connected to the input direct voltage source (Q);
- a series connection of a diode (D2) and a capacitor (C1) disposed between a primary electrode of the semiconductor switch (T1) to be protected and a terminal of the input direct voltage source (Q), with the diode (D2) being polarized in such a manner that, if the semiconductor switch (T1) to be protected is in the blocked state, a charging current for the capacitor C1) is able to flow,
- a further diode (D1) is provided in the circuit including the input direct voltage source (Q), the useful impedance (Ü) and the semiconductor switch (T1) to be protected, with said further diode being polarized in such a manner that, if the semiconductor switch (T1) is in the conductive state, a current is able to flow from the input direct voltage source (Q) through the useful impedance (Ü);
- a further semiconductor switch (T2) by means of which it is possible to establish a connection between the capacitor (C1) and the useful impedance (Ü) for discharging the capacitor (C1) when the semiconductor switch (T1) to be protected is turned on;
- switching means (ÜH, T3, T4) for controlling the further semiconductor switch (T2) to be conductive in synchronism with the conductive state of the semiconductor switch (T1) by means of a control circuit (St) associated with both semiconductor switches (T1, T2) which makes it possible for the further semiconductor switch (T2) to receive its turn-on pulses in synchronism with the semiconductor switch (T1), characterized in that the further semiconductor switch (T2) receives its blocking pulses from the control circuit (St) in synchronism with the semiconductor switch.

2. Use of the arrangement according to Claim 1 for a switch controller, with the useful impedance (Ü), the primary inductance of the switching regulator and the semiconductor to be protected (T1) constituting the switch regulator setting member.

3. An arrangement according to Claim 1, characterized in that the circuit means for controlling the turn-on of the further semiconductor switch (T2) includes an auxiliary transformer (ÜH) whose primary winding (h1) is disposed in the control circuit of the semiconductor switch (T1) to be protected and whose secondary winding (h2) is disposed in a driver stage (T3, T4) for controlling the turn-on of the further semiconductor switch (T2) in such a manner that both semiconductor switches (T1, T2) can be controlled to be conductive simultaneously.

## Revendications

1. Agencement pour exempter un interrupteur à semiconducteur de toute sollicitation de tension de blocage élevée lors de la coupure, présentant les caractéristiques suivantes :
- une source de tension continue d'entrée (Q),
- un groupement série raccordé à la source de tension continue d'entrée (Q) et constitué par une impédance utile (Ü) et par l'interrupteur à semiconducteur à protéger (T1),
- un groupement série constitué par une diode (D2) et par un condensateur (C1) et agencé entre une électrode principale de l'interrupteur à semiconducteur à protéger (T1) et une borne de la source de tension continue d'entrée (Q), la diode (D2) étant branchée dans un sens tel qu'un courant puisse s'écouler pour la charge du condensateur (C1) lorsque l'interrupteur à semiconducteur à protéger (T1) est à l'état bloqué,
une autre diode (D1) dans la maille de courant comportant la source de tension d'entrée (Q), l'impédance utile (Ü) et l'interrupteur à semiconducteur à protéger (T1), cette autre diode étant branchée dans un sens tel qu'un courant venant de la source de tension continue d'entrée (Q) puisse passer par l'impédance utile (Ü) lorsque l'interrupteur à semiconducteur (T1) est à l'état passant,
- un autre interrupteur à semiconducteur (T2) permettant d'établir une liaison entre le condensateur (C1) et l'impédance utile (Ü), pour la décharge du condensateur (C1) lors de l'activation de l'interrupteur à semiconducteur à protéger (T1),
- des moyens de commande (ÜH, T3, T4) pour commander la conduction dudit autre interrupteur à semiconducteur (T2) en synchronisme avec la commande de conduction de l'interrupteur à semiconducteur (T1) au moyen d'un circuit de commande (St) qui est conjugué à l'un des deux interrupteurs à semiconducteur (T1, T2) et qui permet que ledit autre interrupteur à semiconducteur (T2) reçoive ses impulsions d'activation en synchronisme avec l'interrupteur à semiconducteur (T1),
caractérisé par le fait que ledit autre interrupteur à semiconducteur (T2) reçoit du semiconducteur (St) ses impulsions de blocage en synchronisme avec l'interrupteur à semiconducteur.

2. Application de l'agencement selon revendication 1 à un régulateur à commutation, l'impédance utile (Ü) représentant l'inductance principale du régulateur à commutation, et l'interrupteur à semiconducteur protégé (T1) l'organe final du régulateur à commutation.

3. Agencement selon revendication 1, caractérisé par le fait que les moyens de commutation pour commander la conduction dudit autre interrupteur à semiconducteur (T2) sont constitués par un transmetteur auxiliaire (ÜH) ayant un enroulement primaire (h1) disposé dans le circuit de commande du semiconducteur à protéger (T1) et un enroulement secondaire (h2) disposé dans un étage pilote (T3, T4) pour la commande de conduction dudit autre interrupteur à semiconducteur (T2), de manière que les deux interrupteurs à semiconducteur (T1, T2) puissent être commandés à chaque fois simultanément vers la conduction.
